# EUROPEAN PATENT APPLICATION

(11) **EP 4 769 976 A1**
(43) Date of publication of application: **01.07.2026**
(21) Application number: 24223627.1
(22) Date of filing: 30.12.2024
(51) Int. Cl.: H04B 10/2507, G01B 9/02, H01S 5/00, H01S 5/06

(54) **OPTICAL TELECOMMUNICATIONS NETWORK AND A METHOD OF OPERATING THE SAME**

(71) Applicant: British Telecommunications Public Limited Company, London E1 8EE (GB)
(72) Inventor: The designation of the inventor has not yet been filed
(74) Representative: British Telecommunications public limited company Intellectual Property Department

(57) **Abstract**

An optical telecommunications network (100) comprising a/an: Ultra-Stable Signal Optical Source, USS-OS (105), for generating an Ultra-Stable Optical Signal (130), USOS; first Interferometric Stabilisation Device (110-1), ISD, connected to the USS-OS; second ISD (110-2) arranged remotely to the USS-OS and the first ISD; first Optical Link (120-1), OL, connecting an output of the first ISD to a first endpoint (115-1), wherein said first OL is bidirectional; second OL (120-2) connecting the USS-OS to the second ISD; and bridging OL (160-1) arranged proximate the first endpoint and configured to connect the first OL to the second ISD; wherein: the first ISD is configured to: receive, as an input, the USOS from the USS-OS (310); output, to the first OL, a first modified USOS (260-1) by performing a first frequency shift upon the input USOS (320); determine a first Noise Value, NV, associated with the first OL from interferometric processing of the USOS and a first return USOS (265-1), from the first endpoint, or proximate thereto, of the first modified USOS; and subsequently correct the first modified USOS by modifying the first frequency shift so as to counteract the determined first NV, thereby to output a first corrected USOS (370); and the second ISD is configured to: receive (510), as an input, a: from the bridging OL, first noisy USOS (420-1) that is the first modified USOS (260-1) as affected by the first NV due to the first OL; and a second noisy USOS (405-2) that is the USOS as affected by a second NV due to the second OL; generate a second modified USOS (260-2) by performing a second frequency shift, different to the first frequency shift, upon the second noisy USOS (520); determine the second NV from interferometric processing of the first noisy USOS and the second modified USOS; and subsequently correct (560) the second modified USOS by modifying the second frequency shift so as to counteract the determined second NV, thereby to output a second corrected USOS (420-2).

## Description

### Field of Invention

The present invention relates to an optical telecommunications network, and in particular to a fibre optic telecommunications network for disseminating high-fidelity Ultra-Stable Optical Signals using a set of Interferometric Stabilisation Devices.

### Background

Optical telecommunications networks, such as those utilising fibre optic cables, may experience signal noise that destabilises an optical signal, not least by causing frequency-shifting effects; this may arise due to dynamic interactions between the optical signal and the media through which said optical signal is transmitted. Such noise may increase with distance, signal strength, and number of recipients.

Certain applications are particularly sensitive to such noise, including those that utilise high-precision and stable optical signals (e.g. Ultra-Stable Optical Frequencies, USOFs, also referred to as Ultra-Stable Optical Signals, USOS). Such applications may include high-precision timing (e.g. atomic clocks), quantum computing, quantum communication, astronomical observation, high-resolution spectroscopy, interferometry, fundamental physics, and precision metrology. Mitigating the effects of such noise in at least these circumstances is therefore desirable.

However, existing solutions for stabilising optical signals to counteract such noise are susceptible to being overly-expensive and/or impractical, requiring a fundamental overhaul of existing configurations of optical telecommunications networks and/or scaling poorly with increasing numbers of recipients of the USOS.

It is an aim of the present invention to alleviate at least some of the aforementioned problems.

### Statements of Invention

According to a first aspect of the present invention, there is provided: an optical telecommunications network comprising a/an: Ultra-Stable Signal Optical Source, USS-OS, for generating an Ultra-Stable Optical Signal, USOS; first Interferometric Stabilisation Device, ISD, connected to the USS-OS; second ISD arranged remotely to the USS-OS and the first ISD; first Optical Link, OL, connecting an output of the first ISD to a first endpoint, wherein said first OL is bidirectional; second OL connecting the USS-OS to the second ISD; and bridging OL arranged proximate the first endpoint and configured to connect the first OL to the second ISD; wherein:
the first ISD is configured to: receive, as an input, the USOS from the USS-OS; output, to the first OL, a first modified USOS by performing a first frequency shift upon the input USOS; determine a first Noise Value, NV, associated with the first OL from interferometric processing of the USOS and a first return USOS, from the first endpoint, or proximate thereto, of the first modified USOS; and subsequently correct the first modified USOS by modifying the first frequency shift so as to counteract the determined first NV, thereby to output a first corrected USOS; and the second ISD is configured to: receive, as an input, a: from the bridging OL, first noisy USOS that is the first modified USOS as affected by the first NV due to the first OL; and a second noisy USOS that is the USOS as affected by a second NV due to the second OL; generate a second modified USOS by performing a second frequency shift, different to the first frequency shift, upon the second noisy USOS; determine the second NV from interferometric processing of the first noisy USOS and the second modified USOS; and subsequently correct the second modified USOS by modifying the second frequency shift so as to counteract the determined second NV, thereby to output a second corrected USOS. Preferably, the first and second ISDs are further configured to output the first and second corrected USOSs to the first OL and to a second endpoint that is connected, and proximate, to the second ISD, respectively. Optionally, the bridging OL further comprises a/an: first beamsplitter, arranged, at or proximate to, the first endpoint and interfacing with the first OL, for reflecting an optical signal to a first optical bridge; and the first optical bridge for connecting the first beamsplitter to the second ISD. Optionally, the network further comprises a partial reflector, provided on or interfacing with, the first OL, and for reflecting the first noisy USOS, thereby to produce the first return USOS. Preferably, the first and second, and optionally all endpoints, are remote from the USS-OS. Preferably, the first corrected USOS is such that, the first endpoint, effectively, receives the USOS plus a first constant and known frequency shift, in which said frequency shift forms a part of the first frequency shift. Preferably, the second corrected USOS is such that, the second endpoint, effectively, receives the USOS plus a second constant and known frequency shift, in which said frequency shift forms a part of the second frequency shift. In this way, the first and second corrected USOSs may be said to be frequency stabilised. Optionally, the first and/or second first constant and known frequency shift/s are selected by the first or second endpoints, respectively. Preferably, the first return USOS is the first modified USOS having traversed the first OL twice in a return journey, or equally the first noisy USOS returning along the first OL to the first ISD.

Preferably, the first OL comprises a single bidirectional fibre optic link or a pair of one-way fibre optical links, and wherein the second OL comprises a single one-way fibre optical link. Optionally, the first and/or second OL/s is/are a free-space optical link. Preferably, the bridging OL is unidirectional.

Preferably, the network further comprises a/an: third ISD arranged remotely to the USS-OS and the first ISD; third OL connecting the USS-OS to the third ISD; and a further bridging OL arranged proximate the first endpoint and configured to connect the first OL to the third ISD; wherein, the third ISD is configured to: receive, as an input, the: from the further bridging OL, the first noisy USOS; and a third noisy USOS that is generated from the USOS as affected by a third NV due to the third OL; generate a third modified USOS by performing a third frequency shift upon the further noisy USOS; determine the third NV from interferometric processing of the first noisy USOS and the third modified USOS; and subsequently correct the third modified USOS by modifying the third frequency shift so as to counteract the determined third NV, thereby to output a third corrected USOS. Optionally, the third ISD is connected to the USS-OS via the third OL and an intermediate transceiver. Preferably, the first ISD comprises a: first port for receiving the USOS; and a second port for outputting, to the first OL the first modified USOS. Preferably, the second port of the first USOS is further configured to receive the first return USOS. Preferably, the second and third ISDs comprise a: first port for receiving the first noisy USOS from the respective bridging OL; second port for receiving the respective noisy USOS from the corresponding OL; and a third port for outputting the respective corrected USOS to a corresponding endpoint. Preferably, each of the ISDs comprises a photodetector, mixer, controller, synthesiser and control logic for performing the respective interferometric processing and to determine the respective NV. Preferably, each ISD comprises a frequency modulator for performing the respective frequency shift. Optionally, the frequency modulator is in the form of an Acousto-Optic Modulator (AOM) and/or an Electro-Optic Modulator (EOM). Preferably, the third corrected USOS is such that, the third endpoint, effectively, receives the USOS plus a third constant and known frequency shift (which may be selected by the third endpoint), in which said frequency shift forms a part of the third frequency shift.

According to another aspect of the invention, there is provided a method of operating a fibre optic telecommunications network comprising a/an: Ultra-Stable Signal Optical Source, USS-OS, for generating an Ultra-Stable Optical Signal, USOS; first Interferometric Stabilisation Device, ISD, connected to the USS-OS; second ISD arranged remotely to the optical source and the first ISD; first Optical Link, OL, connecting an output of the first ISD to a first endpoint, wherein said first OL is bidirectional; second OL connecting the USS-OS to the second ISD; and bridging OL arranged proximate the first endpoint and configured to connect the first OL to the second ISD; the method comprising the steps of: by the first ISD: receiving, as an input, the USOS from the USS-OS; outputting, to the first OL, a first modified USOS by performing a first frequency shift upon the input USOS; determining a first Noise Value, NV, associated with the first OL from interferometric processing of the USOS and a first return USOS, from the first endpoint or proximate thereto, of the first modified USOS; and subsequently correcting the first modified USOS by modifying the first frequency shift so as to counteract the determined first NV, thereby to output a first corrected USOS; and by the second ISD: receiving, as an input, a: from the bridging OL, first noisy USOS that is the first modified USOS as affected by the first NV due to the first OL; and a second noisy USOS that is the USOS as affected by a second NV due to the second OL; generating a second modified USOS by performing a second frequency shift, different to the first frequency shift, upon the second noisy USOS; determining the second NV from interferometric processing of the first noisy USOS and the second modified USOS; and subsequently correcting the second modified USOS by modifying the second frequency shift so as to counteract the determined second NV, thereby to output a second corrected USOS.

According to yet another aspect of the invention, there is provided a computer-readable carrier medium comprising a computer program, which, when the computer program is executed by a computer, causes the computer to carry out the method described above.

The above summary is not intended to describe each illustrated embodiment or every implementation of the subject matter hereof. The invention includes any novel aspects described and/or illustrated herein. The invention also extends to methods and/or apparatus substantially as herein described and/or as illustrated with reference to the accompanying drawings. The invention is also provided as a computer program and/or a computer program product for carrying out any of the methods described herein and/or for embodying any of the apparatus features described herein, and a computer-readable medium storing thereon a program for carrying out any of the methods and/or for embodying any of the apparatus features described herein. Features described as being implemented in hardware may alternatively be implemented in software, and vice versa.

It should be understood that the individual operations used in the methods of the present teachings may be performed in any order and/or simultaneously, as long as the teaching remains operable. Furthermore, it should be understood that the apparatus and methods of the present teachings can include any number, or all, of the described embodiments, as long as the teaching remains operable.

Any apparatus feature may also be provided as a corresponding step of a method, and vice versa. As used herein, means plus function features may alternatively be expressed in terms of their corresponding structure, for example as a suitably-programmed processor.

Any feature in one aspect of the invention may be applied, in any appropriate combination, to other aspects of the invention. Any, some and/or all features in one aspect can be applied to any, some and/or all features in any other aspect, in any appropriate combination. Particular combinations of the various features described and defined in any aspects of the invention can be implemented and/or supplied and/or used independently.

As used throughout, the word 'or' can be interpreted in the exclusive and/or inclusive sense, unless otherwise specified.

The invention extends to an optical telecommunications network and a method of operating the same as described herein and/or substantially as illustrated with reference to the accompanying drawings. The present invention is now described, purely by way of example, with reference to the accompanying diagrammatic drawings, in which:
Figure 1 shows an optical telecommunications network comprising a set of Interferometric Stabilisation Devices;
Figure 2 shows, in detail, a first Interferometric Stabilisation Device (ISD);
Figure 3 shows a process of operating the optical telecommunications network and the first ISD;
Figure 4 shows, in detail, a second ISD; and
Figure 5 shows a process of operating the optical telecommunications network and the second ISD.

While various embodiments are amenable to various modifications and alternative forms, specifics thereof have been shown by way of example in the drawings and will be described in detail. It should be understood, however, that the intention is not to limit the claimed inventions to the particular embodiments described. On the contrary, the intention is to cover all modifications, equivalents, and alternatives falling within the spirit and scope of the subject matter as defined by, at least, the claims.

### Specific Description

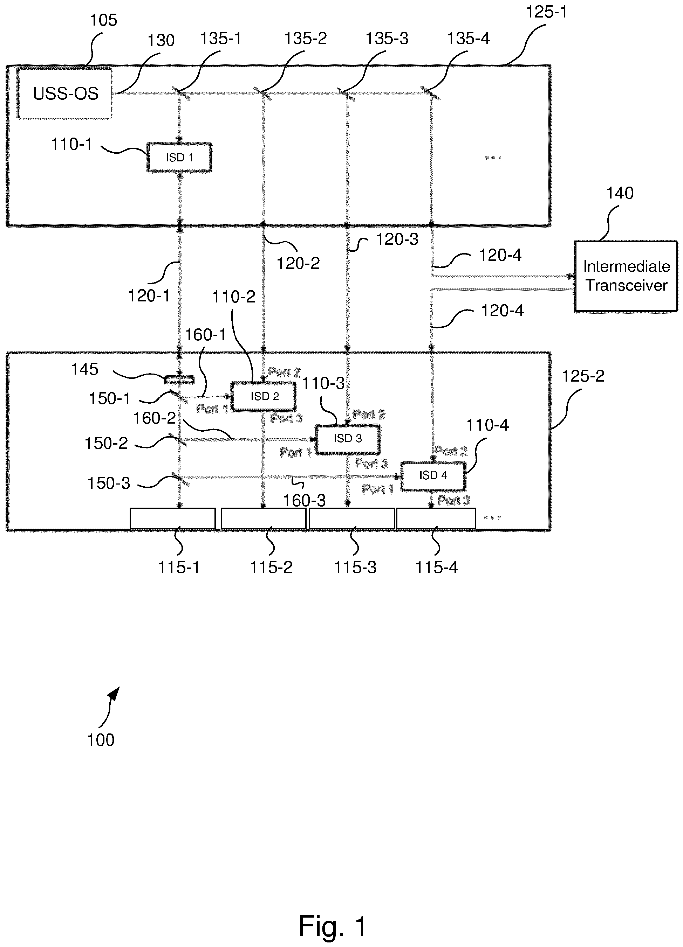

Figure 1 shows an optical telecommunications network 100, in the form of a fibre optical telecommunications network, comprising a/an: a Ultra-Stable-Signal Optical Source (USS-OS) 105; a set of Interferometric Stabilisation Devices 110 (ISDs), including a first 110-1, second 110-2, third 110-3 and fourth 110-4 ISD; a set of endpoints 115, including a first 115-1, second 115-2, third 115-3 and fourth 115-4 endpoint; and a set of Optical Links 120 (OLs) connecting corresponding pairs of IDSs and endpoints, including a first 120-1, second 120-2, third 120-3 and fourth 120-4 OL.

The network 100 is divided into a source side 125-1 and a remote side 125-2, in which the source side comprises the USS-OS 105 and the first ISD 110-1, whereas the remote side comprises the second 110-2, third 110-3 and fourth 110-4 ISDs and all the endpoints 115. The source side and remote side are interconnected by the OLs 120.

The USS-OS 105 is a light source configured to generate and emit an Ultra-Stable Optical Signal 130 (USOS) that is ultra-stable and that has a narrow linewidth (also known as an "Ultra-Stable Optical Frequency"). The USS-OS is, for example, in the form of a high-finesse Fabry-Pérot laser. The USOS has a frequency of *f*₀.

The USOS 130 is disseminated, in parallel, to the first ISD 110-1 and the second 120-2, third 120-3 and fourth 120-4 OLs via a set of primary beamsplitters 135, such that: a first primary beamsplitter 135-1 routes the USOS to the first ISD 110-1; a second primary beamsplitter 135-2 routes the USOS to the second OL 120-2; a third primary beamsplitter 135-3 routes the USOS to the third OL 120-3; and a fourth primary beamsplitter 135-4 routes the USOS to the fourth OL 120-4.

Each of the endpoints 115 are distinct optical receivers configured to receive and utilise (and benefit from the characteristics of) the USOS 130. For example, the endpoints are provided as part of a system for high-precision sensing (e.g. precision spectroscopy), high-precision timing and/or other high-precision metrology, and in particular as part of an atomic clock, hydrogen maser, quantum communication system, quantum encryption system, quantum computer, and/or optical cavity stabilised-laser.

The endpoints 115 are remote from the USS-OS 105, and, in some examples, may be several, tens or hundreds of kilometres away. In the example of the fourth endpoint 115-4, said endpoint is connected to source side 125-1 via an intermediate transceiver 140 (*e.g.* an endpoint itself, or a network routing node, such as a repeater or switch) configured to receive and then forward the USOS on to the fourth endpoint.

The first endpoint 115-1 is connected to the first ISD 110-1 via the first OL 120-1, which is a bidirectional optical link (*e.g.* a single two-way fibre optic cable or two one-way fibre optic cables). The first OL 120-1 comprises, as part of, or proximate a terminus closest to, the first endpoint 115-1, a partial retroreflector 145 that is configured partially (but not wholly) to reflect an inbound optical signal (*e.g*. the USOS) back through the first OL. The partial retroreflector 145 comprises, for example, a fibre Bragg grating, thin-film reflector and/or a partially-reflecting mirror.

The remaining endpoints 115 are connected to the second 120-2, third 120-3 and fourth 120-4 OLs (via the second 110-2, third 110-3 and fourth 110-4 ISDs, respectively), which are each in the form of a one-way optical link permitting transmission only from the corresponding primary beamsplitter 135 to the corresponding ISD (and endpoint).

In addition, the first OL 120-1 comprises a: set of Remote-Side Circulating Beamsplitters 150 (RSCBs), including first 150-1, second 150-2 and third 150-3 RSCBs; and set of Remote-Side Optical Bridges 160 (RSOBs), including first 160-1, second 160-2 and third 160-3 RSOBs.

Each RSCB 150 is: provided on the remote-side 125-2; arranged proximate the first endpoint 115-1; configured to interface with the first OL 120-1, to reflect an inbound optical signal from the first OL towards a corresponding RSOB 160, and to permit an optical signal communicated from the first ISD along the first OL to pass through and on to the first endpoint 115-1.

The first RSOB 160-1 is arranged to interface with, and interconnect, the first RSCB 150-1 and the second ISD 110-2. The second RSOB 160-2 arranged to interface with, and interconnect, the second RSCB 150-2 and the third ISD 110-3. The third RSOB 160-3 arranged to interface with, and interconnect, the second RSCB 150-3 and the fourth ISD 110-4. In this way, each of the second, third and fourth ISDs are effectively, independently, connected to the first ISD 110-1.

Accordingly, by means of the sets of RSCBs and RSOBs, there is provided an architecture that permits an optical signal from the first ISD 110-1 to reach the second, third and fourth ISDs via the OL 120-1.

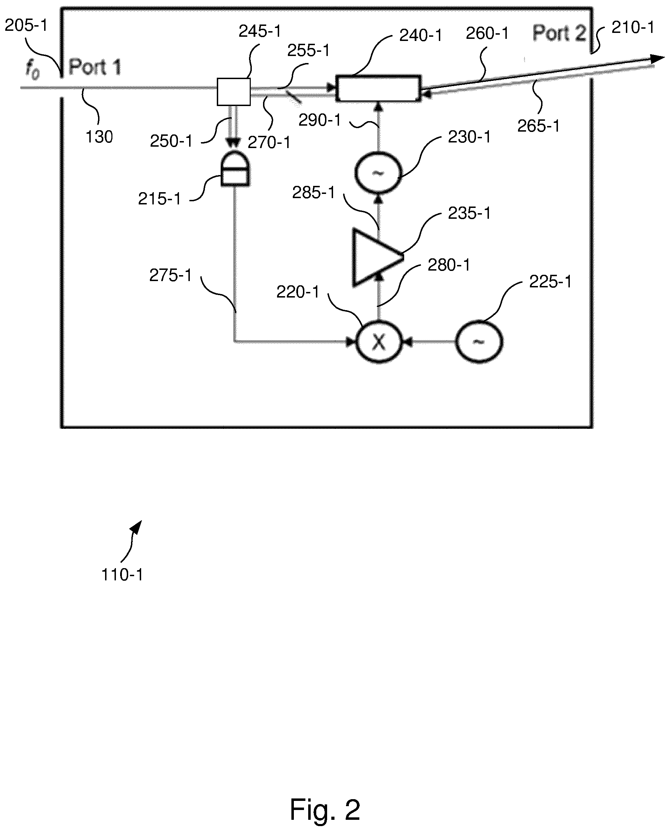

Figure 2 shows the first ISD 110-1 in detail. The first ISD comprises a/an: first port 205-1; second port 210-1; photodetector 215-1; mixer 220-1; first synthesiser 225-1 and a second synthesiser 230-1; controller 235-1; and frequency modulator (or shifter) 240-1. The first ISD 110-1 is arranged and configured such that the USOS 130 is received by the first port 205-1. The USOS is subsequently simultaneously distributed (*e.g*. via a mirrored half-waveplate and polarised beamsplitter arrangement 245-1) to the photodetector 215-1 and the frequency modulator 240-1. The photodetector is, for example, in the form of a photodiode (*e.g*. an avalanche photodiode) and/or a photomultiplier tube, and is specifically configured to measure a frequency of an input optical signal (*e.g*. the USOS). The frequency modulator is configured to modify a frequency of the USOS 130, and is, for example, in the form of an Acousto-Optic Modulator (AOM) and/or an Electro-Optic Modulator (EOM).

The frequency modulator 240-1 is configured to modify the frequency of the USOS 130, *f₀,* by a modulation frequency, *fₘ,* and a regulation frequency, *fᵣ.* The frequency modulator is further provided with inputs from the first 205-1 and second 210-1 ports, and with outputs to the photodetector 215-1 and to the second port 210-1. The second port interfaces with the first OL 120-1.

The photodetector 215-1 is configured to output, to the mixer 220-1, a measure of frequency of an input optical signal (*e.g.* the USOS 130, as from the first port 205-1), which is received at the mixer as a first input. The first synthesiser 225-1 is configured to generate a signal and to communicate said signal to the mixer 220-1 as a second input. The mixer is configured to determine a difference between the first and second inputs, and then to output said difference to the controller 235-1.

As described in more detail below, the controller 235-1 is configured to process the difference between the first and second inputs so as to determine a frequency modulation, for the frequency modulator 240-1, at which dynamic frequency-shifting noise from the first OL 120-1 is effectively negated (thereby stabilising signal frequency) at the point of receipt by the first endpoint 115-1.

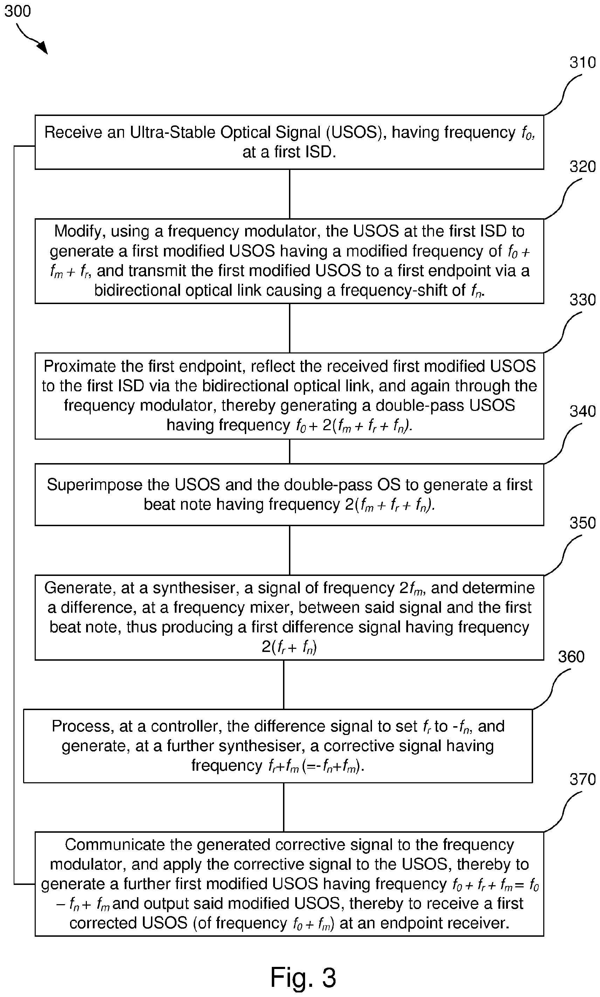

Figure 3 shows a process 300 for operating the network 100, and in particular of operating the first ISD 115-1.

At a first step 310, the first ISD 115-1 receives, at the first port 205-1, the USOS 130 from the USS-OS 105.

At a second step 320, the received USOS 130 is simultaneously directed (by arrangement 245-1) to the photodetector 215-1 via a first path 250-1 and to the frequency modulator 240-1 via a second path 255-1.

As part of the second path 255-1, the frequency modulator 240-1 performs a frequency shift upon the USOS 130 by applying the modulation frequency, *fₘ,* and the regulation frequency, *fᵣ,* thereby generating a first modified USOS 260-1 having a frequency of (*f₀ + fₘ* + *fᵣ*)*.* The modulation frequency is used to provide an initial (and static) frequency offset for the USOS (e.g. as set by a user, including an operator of the USS-OS 105 or a user of the first endpoint 115-1), whereas the regulation frequency, *fᵣ,* is a dynamic corrective value that is effectively determined by the first ISD to cancel-out noise from the first OL 120-1, as described in more detail below.

The first modified USOS 260-1 is communicated from the frequency modulator 240-1 to the second port 210-1 and is then output from the first ISD 110-1 to the first OL 120-1. The first modified USOS is then communicated along the first OLto the partial retroreflector 145, and thus also to the first endpoint 115-1.

At a next step 330, a first reflected component of the first modified USOS 260-1 is received at the frequency modulator 240-1 said reflected component having traversed the first OL 120-1, reflected off the partial retroreflector 145, travelled back along the first OL, and re-entered the first ISD via the second port 210-1. In addition, a pass-through component of the first modified USOS continues beyond the partial retroreflector 145 (and the set of RSCBs 150) to the first endpoint 115-1.

The first OL 120-1 causes frequency-shifting noise effects upon optical signals (e.g. the first modified USOS 260-1) of *fₙ*. Such effects arise, for example, due to Stimulated Brillouin Scattering (SBS), which results in backward-scattered light at a shifted frequency. Furthermore, temperature and mechanical changes in a fibre optical link may result in frequency-shifting noise effects. Along the fourth OL 120-4, additional frequency-shifting noise may arise from componentry (*e.g*. amplifiers, band filters, and isolators) within the intermediate transceiver 140.

Accordingly, at the partial retroreflector 145, the first modified USOS 260-1 is effectively shifted by *fₙ*, and, upon return to the frequency modulator 240-1, the first reflected component is effectively (and within reasonable approximation) further shifted by an additional *fₙ*, thereby resulting in a first return USOS 265-1 having a frequency of (*f₀ + fₘ* + *fᵣ +* 2*fₙ*)*.*

The first return USOS 265-1 passes into, and through, the frequency modulator 240-1, whereupon the frequency modulator again applies a frequency shift of (*fₘ* + *fᵣ*)*,* thereby resulting in a first double-pass USOS 270-1 having a frequency of (*f₀+* 2(*fₘ* + *fᵣ* + *fₙ*))*.*

At a next step 340, the first double-pass USOS 270-1 is output from the frequency modulator 240-1 to the photodetector 215-1. At the same time, the photodetector receives the USOS 130 from the first port 205-1. Accordingly, when the polarisation states of the incident first double-pass USOS and USOS are non-orthogonal, an interferometrically generated first beat note 275-1 results, having a first beat frequency, *f_{b},* of *2(fₘ* + *fᵣ + fₙ).* The first beat note is output from the photodetector to the mixer 220-1, and is received at the mixer as the first input.

At a next step 350, the first synthesiser 225-1 generates a signal of frequency 2*fₘ*, and outputs said signal to the mixer 220-1, which is received at the mixer as the second input. The mixer then mixes the first input - *f_{b}* 275-1 - with the second input - *2fₘ* - to output a difference between said inputs, and thus a first difference signal 280-1 having frequency *2(fᵣ + fₙ).*

At a next step 360, the first difference signal 280-1 is output by the mixer 220-1 to the controller 235-1, and the controller performs processing to determine a value of *fᵣ* at which *fᵣ = -fₙ* (*i.e.* on the basis that the first difference signal, *2(fᵣ+ fₙ),* equals zero).

At a next step 370, the controller 235-1 then communicates said determined value of *fᵣ* 285-1 to the second synthesiser 230-1. Using the determined value of *fᵣ,* the second synthesiser 230-1 generates a first corrective signal 290-1 having a frequency at which (*fᵣ + fₘ*) *=* (*-fₙ + fₘ*)*,* and the first corrective signal is output from the second synthesiser to the frequency modulator 240-1, which adopts the determined value of *fᵣ*.

Accordingly, using the determined value of *fᵣ* 285-1, and since said value is equal to -*fₙ*, the USOS 130 that continues to be received by the frequency modulator 240-1 from the USS-OS 105 (and via the second path 255-1) is frequency shifted (by *fₘ* and said determined value of f*ᵣ*) such that the ongoing first modified USOS 260-1 has a frequency of (*f₀* - *fₙ* + *fₘ*)*,* which is output from the frequency modulator to the first OL 120-1 (via the second port 210-1) and, at the partial retroreflector 145 said first modified USOS - the first corrected USOS - has a frequency of (*f₀ + fₘ+ fᵣ + fₙ = f₀ + fₘ*)*.* Thus, the first endpoint 115-1 effectively receives an optical signal having frequency (*f₀ + fₘ*)*.* Accordingly, the first endpoint receives an ultra-stable optical signal that is frequency shifted (by a constant *fₘ*) over the USOS 130, but for which the dynamic frequency-shifting noise effects of the fist OL, *fₙ*, are cancelled-out. The value of *fₘ* is available to be communicated to the first endpoint (or set by said endpoint) so that the first endpoint is capable of cancelling-out said value.

After step 370, process 300 re-iterates to step 310 such that the USOS 130 from the USS-OS 105 continues to be modified using, at first, the previously determined value of *fᵣ* 285-1 from preceding step 360 and therefore to continue correcting for subsequent variation in *fₙ.*

All else being equal, with increasing distance between the USS-OS 105 and a given endpoint 115, and/or where the USOS 130 is to be distributed across an increasing number of endpoints 115, input power may need to increase correspondingly in order to maintain signal fidelity. However, certain frequency-shifting noise effects arising in optical links (including SBS) grow exponentially with input signal power of an optical signal. In addition, as the input signal power increases, the output power from a fibre will saturate after a certain level due to these non-linear effects and prevent more power being disseminated across long distances (and therefore limiting the number of applications to which a signal can be disseminated). To help annul this detrimental effect, an optical amplifier can be placed at the remote location for USOS power amplification, however the amplifier will destabilise the USOS. Instead, a further set of ISDs, namely the second 115-2, third 115-3 and fourth 115-4 ISDs, are provided to cancel-out noise in the second 120-2, third 120-3 and fourth 120-4 OLs that serve the further endpoints by building upon the processing undertaken the first ISD 110-1.

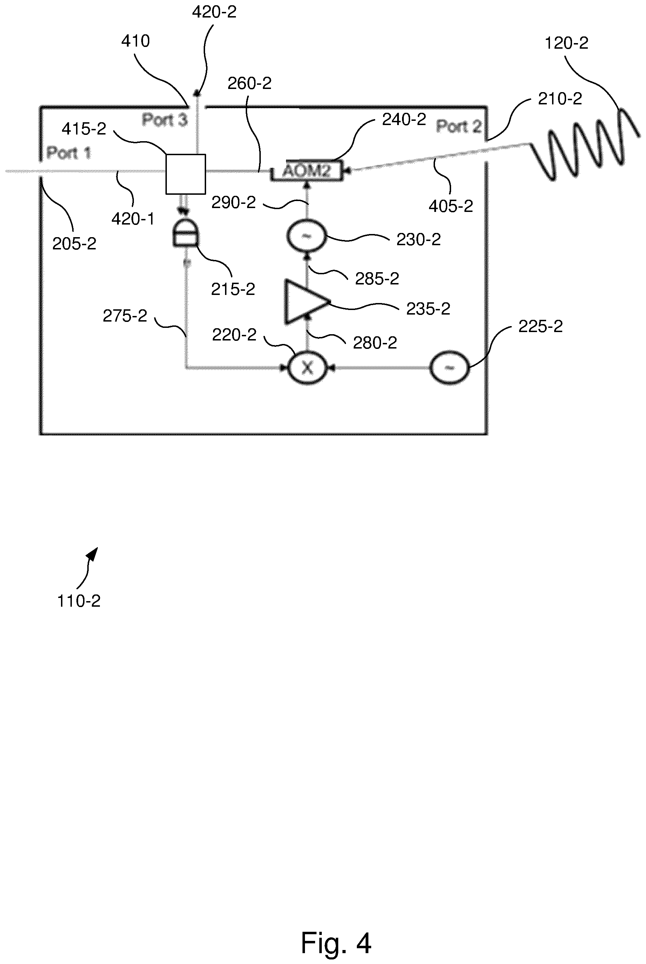

Figure 4 shows the second ISD 110-2 in detail. The second ISD is a modified version of the first ISD 110-1, and comprises corresponding components and features (identified using identical reference numerals suffixed with "-2" to denote a component being a constituent of the second ISD specifically), including the: first port 205-2; second port 210-2; photodetector 215-2; mixer 220-2; first synthesiser 225-2 and a second synthesiser 230-2; controller 235-2; and frequency modulator (or shifter) 240-2. In addition, the second ISD comprises a third port 410, which is configured to interface with the first RSOB 160-1.

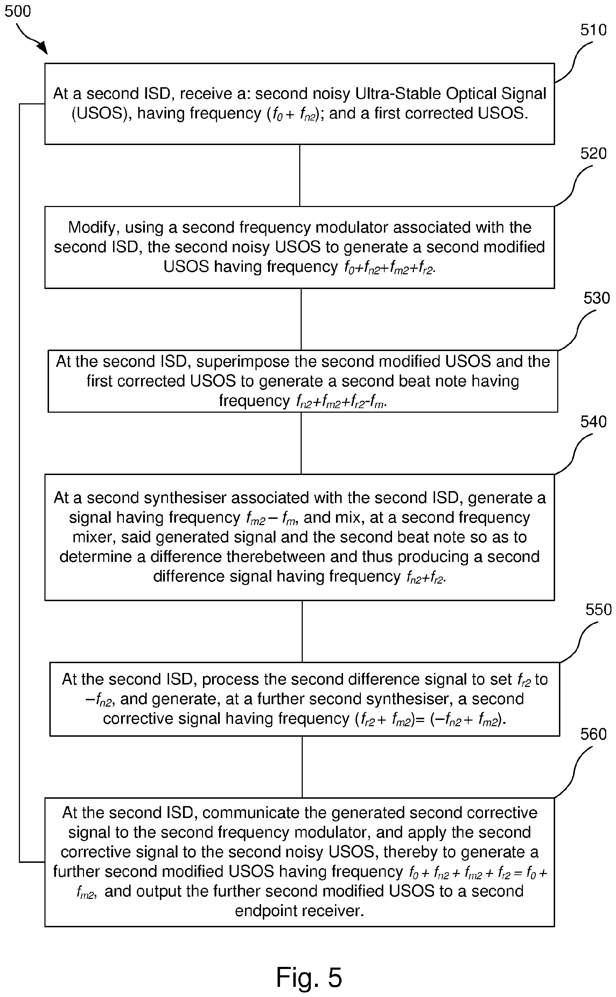

Figure 5 shows a process 500, for performance concurrently with process 300, for operating the network 100, and in particular for operating the second ISD 110-2.

At a first step 510, the second ISD 110-2 receives, at the second port 210-2 and from the second OL120-2, a second noisy USOS 405-2, which is the USOS 130 having been affected by frequency-shifting noise - of frequency *fₙ₂* - from the second OL120-2 (a corresponding first noisy USOS, which is not discussed, is the first modified USOS having been affected by the noise from the first OL, *fₙ*)*.* The second noisy USOS has a frequency of (*f₀* + *fₙ₂*). Concurrently, the second ISD 110-2 receives, at the first port 205-2 (and from the first RSOB 160-1), the first corrected USOS 420-1 (*i.e.* the first modified USOS 260-1, subsequently affected by *fₙ* from the first OL, and thus having a frequency, at receipt, of *f₀* + *fₘ*)*.*

At a second step 520, the frequency modulator 240-2 performs a frequency shift upon the second noisy USOS 405-2 (from the second port 210-2) by applying a second modulation frequency, *fₘ₂,* and a second regulation frequency, *fᵣ₂*, thereby generating a second modified USOS 260-2 having a modified frequency of (*f₀* + *fₙ₂* + *fₘ₂* + *fᵣ₂*)*.* The second modified USOS 260-2 is output from the frequency modulator 240-2 and is simultaneously directed to the photodetector 215-2 and the third port 410 (via a mirrored half-waveplate and polarised beamsplitter arrangement 415-2). Simultaneously, the first corrected USOS 3420-1 is also directed to the photodetector 215-2 (via the mirrored half-waveplate and polarised beamsplitter arrangement 415-2).

At a next step 530, the photodetector receives the second modified USOS 260-2 and the first corrected USOS 420-1. Accordingly, when the polarisation states of the incident the second modified USOS 260-2 and the first corrected USOS 420-1 are non-orthogonal, an interferometrically generated second beat note 275-2 results, having a second beat frequency, *f_{b2},* of (*fₙ₂* + *fₘ₂* + *fᵣ₂* - *fₘ*)*.* The second beat note is output from the photodetector to the mixer 220-2, and is received at the mixer as the corresponding first input.

The values of *fₘ* and *fₘ₂* are selected to be non-equal so as to enable appropriate signal discrimination by the first 110-1 and second 110-2 ISDs of the respective associated modulation frequencies (*e.g.* such that the first ISD selects for processing only the signal with the *fₘ* component and no *fₘ₂* component, *etc*.). As such, the modulation frequencies for each ISD are sufficiently different so that each beat note 275 is correlated by only the appropriate corresponding ISD. For example, *fₘ =* 50MHz such that the first beat note 275-1 for the first OL 120-1 is at (approximately) 100MHz (where *fₙ* << *fₘ*)*,* and *fₘ₂ =* 1 10MHz (*e.g.* with the modulation frequencies increasing by 10MHz with each successive ISD), such that the second beat note 275-2 is at (approximately) 10MHz (and 110MHz, as a result of addition of the first and second beat notes). Therefore, in this example, the photodetector 215-1 is configured to identify the first beat note at 100MHz, and the photodetector 215-2 is configured to identify the second beat note at 10MHz.

At a next step 540, the first synthesiser 225-2 generates a signal of frequency *fₘ₂ - fₘ,* and outputs said signal to the mixer, which is received at the mixer 220-2 as the second input. The mixer then mixes the first input - *f_{b2}* 275-2 - with the second input - (*fₘ₂* - *fₘ*) - to output a difference between said inputs, and thus a second difference signal 280-2 having frequency (*fₙ₂* + *fᵣ₂*).

At a next step 550, using the second difference signal 280-2 from the mixer 220-2, the controller performs processing to determine a value of *fᵣ₂* at which *fᵣ₂* = -fₙ₂. The controller 235-2 then communicates said determined value of *fᵣ₂* 285-2 to the second synthesiser 230-2. Using the determined value of *fᵣ₂* 285-2, the second synthesiser generates a second corrective signal 290-2 having a frequency at which (*fᵣ₂* = -*fₙ₂*), and this second corrective signal is output from the second synthesiser to the frequency modulator 240-2, which adopts the determined value of *fᵣ₂*.

Accordingly, using the determined value of *fᵣ₂* 290-2, and since said value is equal to -*fₙ₂*, the second noisy USOS 405-2 that continues to be received by the frequency modulator 240-2 from the second port 210-2 is frequency shifted (by *f*ₘ₂ and said determined value of *fᵣ₂*) such that the second modified USOS 260-2 now has a frequency of (*f₀* + *fₙ₂* + *fₘ₂* + *fᵣ₂*) *=* (*f₀ + fₘ₂*), which is output - as the second corrected USOS 420-2 - from the third port 410 and on to the second endpoint 115-2, which effectively receives an optical signal having frequency (*f₀* + *fₘ₂*)*.* Accordingly, the second endpoint receives an ultra-stable optical signal that is frequency shifted (by a constant *fₘ₂*) over the USOS 130, but that is frequency-stabilised, having the dynamic frequency-shifting noise of the second OL 120-2, *fₙ₂*, cancelled-out. The value of *fₘ₂* is available to be communicated to the second endpoint (or set by said endpoint) so that the second endpoint is capable of cancelling-out said value.

After step 560, process 500 re-iterates to step 510 such that the second noisy USOS 405-2 continues to be modified using, at first, the previously determined value of *fᵣ₂* 285-2 and therefore to account for subsequent variation in *fₙ₂.*

The third 110-3 and fourth 110-4 ISDs effectively correspond to the second ISD 110-2, and are operated in a corresponding manner to the second ISD, as per process 500, such that a corresponding input of the first corrected USOS 420-1 is provided (*i.e*. by means, of the second and third, respectively, RSCBs 150 and RSOB 160), thereby enabling determination and cancellation of the frequency-shifting noise effects of the corresponding third 120-3 and fourth 120-4 OLs.

### Alternatives and Modifications

It will be appreciated that the telecommunications network 100 is available to comprise any number of ISDs 110 and endpoints 115 configured according to the principles described above so as to distribute a noise-cancelled USOS across optical links.

In an alternative, any of the OLs 120 are available to comprise free space optical links. For example, any of the ISDs 110 and/or endpoints 115 are available to form part of a satellite or space-based communication device.

In one embodiment, the system and/or its components or subsystems can include computing devices, microprocessors, modules and other computer or computing devices, which can be any programmable device that accepts digital data as input, is configured to process the input according to instructions or algorithms, and provides results as outputs. In one embodiment, computing and other such devices discussed herein can be, comprise, contain or be coupled to a Central Processing Unit (CPU) configured to carry out the instructions of a computer program. Computing and other such devices discussed herein are therefore configured to perform basic arithmetical, logical, and input/output operations.

Computing and other devices discussed herein can include memory. Memory can comprise volatile or non-volatile memory as required by the coupled computing device or processor to not only provide space to execute the instructions or algorithms, but to provide the space to store the instructions themselves. In one embodiment, volatile memory can include random access memory (RAM), dynamic random access memory (DRAM), or static random access memory (SRAM), for example. In one embodiment, non-volatile memory can include read-only memory, flash memory, ferroelectric RAM, hard disk, floppy disk, magnetic tape, or optical disc storage, for example. The foregoing lists in no way limit the type of memory that can be used, as these embodiments are given only by way of example and are not intended to limit the scope of the disclosure.

In one embodiment, the system or components thereof can comprise or include various modules or engines, each of which is constructed, programmed, configured, or otherwise adapted to autonomously carry out a function or set of functions. The term "engine" as used herein is defined as a real-world device, component, or arrangement of components implemented using hardware, such as by an application specific integrated circuit (ASIC) or field programmable gate array (FPGA), for example, or as a combination of hardware and software, such as by a microprocessor system and a set of program instructions that adapt the engine to implement the particular functionality, which (while being executed) transform the microprocessor system into a special-purpose device. An engine can also be implemented as a combination of the two, with certain functions facilitated by hardware alone, and other functions facilitated by a combination of hardware and software. In certain implementations, at least a portion, and in some cases, all, of an engine can be executed on the processor(s) of one or more computing platforms that are made up of hardware (*e.g*., one or more processors, data storage devices such as memory or drive storage, input/output facilities such as network interface devices, video devices, keyboard, mouse or touchscreen devices, etc.) that execute an operating system, system programs, and application programs, while also implementing the engine using multitasking, multithreading, distributed (e.g., cluster, peer-peer, cloud, etc.) processing where appropriate, or other such techniques. Accordingly, each engine can be realized in a variety of physically realizable configurations, and should generally not be limited to any particular implementation exemplified herein, unless such limitations are expressly called out. In addition, an engine can itself be composed of more than one sub-engines, each of which can be regarded as an engine in its own right. Moreover, in the embodiments described herein, each of the various engines corresponds to a defined autonomous functionality; however, it should be understood that in other contemplated embodiments, each functionality can be distributed to more than one engine. Likewise, in other contemplated embodiments, multiple defined functionalities may be implemented by a single engine that performs those multiple functions, possibly alongside other functions, or distributed differently among a set of engines than specifically illustrated in the examples herein.

Various embodiments of systems, devices, and methods have been described herein. These embodiments are given only by way of example and are not intended to limit the scope of the claimed inventions. It should be appreciated, moreover, that the various features of the embodiments that have been described may be combined in various ways to produce numerous additional embodiments. Moreover, while various materials, dimensions, shapes, configurations and locations, etc. have been described for use with disclosed embodiments, others besides those disclosed may be utilized without exceeding the scope of the claimed inventions.

Persons of ordinary skill in the relevant arts will recognise that embodiments may comprise fewer features than illustrated in any individual embodiment described above. The embodiments described herein are not meant to be an exhaustive presentation of the ways in which the various features may be combined. Accordingly, the embodiments are not mutually exclusive combinations of features; rather, embodiments can comprise a combination of different individual features selected from different individual embodiments, as understood by persons of ordinary skill in the art. Moreover, elements described with respect to one embodiment can be implemented in other embodiments even when not described in such embodiments unless otherwise noted. Although a dependent claim may refer in the claims to a specific combination with one or more other claims, other embodiments can also include a combination of the dependent claim with the subject matter of each other dependent claim or a combination of one or more features with other dependent or independent claims. Such combinations are proposed herein unless it is stated that a specific combination is not intended. Furthermore, it is intended also to include features of a claim in any other independent claim even if this claim is not directly made dependent to the independent claim.

Moreover, reference in the specification to "one embodiment," "an embodiment," or "some embodiments" means that a particular feature, structure, or characteristic, described in connection with the embodiment, is included in at least one embodiment of the teaching. The appearances of the phrase "in one embodiment" in various places in the specification are not necessarily all referring to the same embodiment.

Any incorporation by reference of documents above is limited such that no subject matter is incorporated that is contrary to the explicit disclosure herein. Any incorporation by reference of documents above is further limited such that no claims included in the documents are incorporated by reference herein. Any incorporation by reference of documents above is yet further limited such that any definitions provided in the documents are not incorporated by reference herein unless expressly included herein.

Each feature disclosed herein, and (where appropriate) as part of the claims and drawings may be provided independently or in any appropriate combination.

Any reference numerals appearing in the claims are for illustration only and shall not limit the scope of the claims.

## Claims

1. An optical telecommunications network comprising a/an:
Ultra-Stable Signal Optical Source, USS-OS, for generating an Ultra-Stable Optical Signal, USOS;
first Interferometric Stabilisation Device, ISD, connected to the USS-OS;
second ISD arranged remotely to the USS-OS and the first ISD;
first Optical Link, OL, connecting an output of the first ISD to a first endpoint, wherein said first OL is bidirectional;
second OL connecting the USS-OS to the second ISD; and
bridging OL arranged proximate the first endpoint and configured to connect the first OL to the second ISD;
wherein:
the first ISD is configured to:
receive, as an input, the USOS from the USS-OS;
output, to the first OL, a first modified USOS by performing a first frequency shift upon the input USOS;
determine a first Noise Value, NV, associated with the first OL from interferometric processing of the USOS and a first return USOS, from the first endpoint, or proximate thereto, of the first modified USOS; and
subsequently correct the first modified USOS by modifying the first frequency shift so as to counteract the determined first NV, thereby to output a first corrected USOS; and
the second ISD is configured to:
receive, as an input, a: from the bridging OL, first noisy USOS that is the first modified USOS as affected by the first NV due to the first OL; and a second noisy USOS that is the USOS as affected by a second NV due to the second OL;
generate a second modified USOS by performing a second frequency shift, different to the first frequency shift, upon the second noisy USOS;
determine the second NV from interferometric processing of the first noisy USOS and the second modified USOS; and
subsequently correct the second modified USOS by modifying the second frequency shift so as to counteract the determined second NV, thereby to output a second corrected USOS.

2. An optical telecommunications network according to Claim 1, wherein the first OL comprises a single bidirectional fibre optic link or a pair of one-way fibre optical links, and wherein the second OL comprises a single one-way fibre optical link.

3. An optical telecommunications network according to any preceding claim, further comprising a/an:
third ISD arranged remotely to the USS-OS and the first ISD;
third OL connecting the USS-OS to the third ISD; and
a further bridging OL arranged proximate the first endpoint and configured to connect the first OL to the third ISD;
wherein, the third ISD is configured to:
receive, as an input, the: from the further bridging OL, the first noisy USOS; and a third noisy USOS that is generated from the USOS as affected by a third NV due to the third OL;
generate a third modified USOS by performing a third frequency shift upon the further noisy USOS;
determine the third NV from interferometric processing of the first noisy USOS and the third modified USOS; and
subsequently correct the third modified USOS by modifying the third frequency shift so as to counteract the determined third NV, thereby to output a third corrected USOS.

4. A method of operating a fibre optic telecommunications network comprising a/an:
Ultra-Stable Signal Optical Source, USS-OS, for generating an Ultra-Stable Optical Signal, USOS;
first Interferometric Stabilisation Device, ISD, connected to the USS-OS;
second ISD arranged remotely to the optical source and the first ISD;
first Optical Link, OL, connecting an output of the first ISD to a first endpoint, wherein said first OL is bidirectional;
second OL connecting the USS-OS to the second ISD; and
bridging OL arranged proximate the first endpoint and configured to connect the first OL to the second ISD;
the method comprising the steps of:
by the first ISD:
receiving, as an input, the USOS from the USS-OS;
outputting, to the first OL, a first modified USOS by performing a first frequency shift upon the input USOS;
determining a first Noise Value, NV, associated with the first OL from interferometric processing of the USOS and a first return USOS, from the first endpoint or proximate thereto, of the first modified USOS; and
subsequently correcting the first modified USOS by modifying the first frequency shift so as to counteract the determined first NV, thereby to output a first corrected USOS; and
by the second ISD:
receiving, as an input, a: from the bridging OL, first noisy USOS that is the first modified USOS as affected by the first NV due to the first OL; and a second noisy USOS that is the USOS as affected by a second NV due to the second OL;
generating a second modified USOS by performing a second frequency shift, different to the first frequency shift, upon the second noisy USOS;
determining the second NV from interferometric processing of the first noisy USOS and the second modified USOS; and
subsequently correcting the second modified USOS by modifying the second frequency shift so as to counteract the determined second NV, thereby to output a second corrected USOS.

5. A computer-readable carrier medium comprising a computer program, which, when the computer program is executed by a computer, causes the computer to carry out the steps of Claim 4.
